# EUROPEAN PATENT APPLICATION

(11) **EP 2 639 591 A1**
(43) Date of publication of application: **18.09.2013**
(21) Application number: 11839844.5
(22) Date of filing: 10.11.2011
(51) Int. Cl.: G01R 31/00, G01R 31/30

(54) **DEVICE FOR INSPECTING ELECTRIC FIELD VARIATION RESISTANCE OF ELECTRONIC DEVICES AND METHOD FOR DETECTING ELECTRIC FIELD VARIATION RESISTANCE OF ELECTRONIC DEVICES**

(30) Priority: 10.11.2010 JP 2010251429
(71) Applicant: Tokyo Electronics Trading Co., Ltd., Tachikawa-shi, Tokyo 190-0023 (JP)
(72) Inventor: HONDA, Masamitsu, Tokyo 206-0823 (JP); ISOFUKU, Satoshi, Tokyo 190-0023 (JP); ARAI, Hideki, Tokyo 190-1212 (JP)
(74) Representative: TBK
(86) International application number: PCT/JP2011/075943
(87) International publication number: WO 2012/063902

(57) **Abstract**

In a testing apparatus, an electronic equipment to be an equipment under test; EUT is exposed to an electric field by unit of an emission electrode, and an intensity of the electric field applied to the electronic equipment during a test is fluctuated by electric field fluctuating unit. Operating characteristics of the electronic equipment are tested by generating induction charging inside the electronic equipment by the fluctuation electric field during the test. As a result, it becomes possible to test malfunction caused by a discharge phenomenon generated inside the electronic equipment, which cannot be tested with a conventional ESD testing apparatus.

## Description

### Field

The present invention relates to a technique for testing immunity of an electronic equipment when exposed to a fluctuating electric field.

### Background

Along with an increase in the integration density of semiconductor integrated circuit components, it has been increasingly difficult to maintain the strength (immunity against malfunction and damage) of an electronic equipment containing semiconductor components and the like against electrostatic discharge. Manufacturers of semiconductor components and manufacturers of printed circuit boards have improved techniques for controlling electrostatic discharge (ESD) to be confined within a safe range by using a technique for preventing charging or by reinforcing a ground. In an actual usage and operational environment, however, it is often difficult to appropriately control static electricity. Therefore, an ESD immunity test is conducted in order to guarantee sufficient immunity of an electronic equipment product being used when ESD is applied externally thereto.

This immunity test is defined by International Standard IEC 61000-4-2, associated standards thereof (ISO 10605, JASO D101), and the like. Typically, an ESD testing apparatus using an ESD gun is used. The ESD testing apparatus generates contact discharge by bringing a contact terminal (discharge rod) of the ESD gun into contact with a conducting surface region of an equipment under test (EUT) such as an electronic equipment with a power source ON and by pulling a trigger switch of the ESD gun. In a case where the surface of the equipment under test is made of an insulating material, the contact terminal of the ESD gun with the trigger switch being pulled is approached to the equipment under test so as to discharge in the air. In any case, ESD is externally applied to the equipment under test, and an influence thereby is observed. During the ESD test, whether or not the equipment under test operates normally, whether or not recovery to a normal state is performed even if instantaneous malfunction occurs, and the like are checked.

There is also a case where a horizontal coupling plate and a vertical coupling plate are disposed around the equipment under test and ESD is applied thereto so as to test immunity against indirect discharge.

### Citation List

### Non Patent Literature

Non Patent Literature 1: Electrostatic discharge immunity test IEC 61000-4-2

### Summary

### Technical Problem

Even the electronic equipment on which a detailed and rigorous test has been conducted in accordance with the above-described International Standard IEC 61000-4-2 may possibly cause serious malfunction during a winter dry period, for example. In automatic ticket gates of public transportation facilities, for example, malfunction has occurred frequently during winter, leading to a chaotic mess.

In general, the root cause of this malfunction has not been revealed. According to the new knowledge obtained by the present inventors, which is unknown to the public, when a person wearing easily-charged clothing such as a chemical fiber passes through an automatic ticket gate, a component of a control circuit inside the ticket gate covered with an insulator results in induction charging thereof due to a high-voltage electrostatic field generated from the charged clothing and the electrostatic charge discharges to the adjacent grounded metal. Due to the discharge generated inside the electronic equipment, a strong transient electromagnetic wave is emanated. This impacts the control circuit placed nearby, inducing the malfunction thereof.

Moreover, similar malfunction may occur also in a control panel of a control room in a power plant, an air traffic control, a chemical plant, or the like, for example. An operator typically operates a control panel while seated. If the operator attempts to operate a part placed at a high position upon standing up from the chair, malfunction occurs. It can be considered that the capacitance of the operator sitting on the chair is about 300 pF. When the operator stands up, however, it is decreased to about 100 pF. With the charge amount accumulated in the operator being constant, if the capacitance is reduced to one-third, the potential of the operator jumps threefold instantaneously. Such potential fluctuation in the operator causes induction charging on the electronic components inside the control panel as with the above-described passing movement in the automatic ticket gate, thereby possibly inducing the malfunction thereof.

However, there is a problem that the evaluation of the state as described above cannot be conducted at all with conventional IEC 61000-4-2 Test using the ESD testing apparatus. Specifically, this ESD testing apparatus is a device for testing immunity against a direct discharge phenomenon generated by external contact (of an operating human body) with an electronic equipment ( equipment under test; EUT) or an indirect discharge phenomenon generated around the electronic equipment. In the above-described cases, however, malfunction may occur due to a discharge phenomenon generated inside the electronic equipment even without discharge between a human body and the electronic equipment.

A recent electronic equipment, in particular, rarely employs a metal plate for its case. In most cases, it employs an insulator such as a plastic case. In a case where such an insulating case is employed, the electrostatic shielding effect thereof is low. Thus, if a charged voltage therearound is significantly fluctuated, the voltage of an ungrounded conductor inside the electronic equipment is greatly changed due to the induction charging thereof. If a grounded conductor exists at a position immediately close to the ungrounded conductor whose voltage has been changed greatly via a narrow gap therebetween, air(dielectric) breakdown occurs in the gap therebetween and spark discharge is thereby generated. In a case where a space between the ungrounded conductor and the grounded conductor is equal to or less than 0.1 mm, for example, spark discharge is generated when the potential difference therebetween is about 1000 V or less. In a case of 0.05 mm, for example, spark discharge is generated at about 700 V. The discharge phenomenon by the ungrounded conductor inside the insulating case due to such a fluctuating electrostatic field cannot be evaluated with the conventional ESD testing apparatus.

The present invention has been made in view of the above-described problem, and an object thereof is to provide a fluctuating electric field immunity testing technique for testing malfunction caused by a discharge phenomenon generated inside an electronic equipment, which cannot be tested with the conventional ESD testing apparatus.

### Solution to Problem

Owing to the earnest researches made by the present inventors, the above-described object is achieved by the following means.

Specifically, the present invention achieving the above-described object is an apparatus for testing immunity of an electronic equipment against a fluctuating electric field, the apparatus including: an emission electrode for making an electronic equipment to be an equipment under test; EUT exposed to an electric field; and electric field fluctuating means for fluctuating an intensity of the electric field applied to the electronic equipment during a test. The apparatus is characterized in that operating characteristics of the electronic equipment are tested by generating induction charging inside the electronic equipment by means of the fluctuation of the electric field during the test.

The apparatus for testing immunity of an electronic equipment against a fluctuating electric field, achieving the above-described object, is further characterized in that the electric field fluctuating means includes a voltage control device that fluctuates the intensity of the electric field by changing a voltage supplied to the emission electrode.

The apparatus for testing immunity of an electronic equipment against a fluctuating electric field, achieving the above-described object, is further characterized in that the electric field fluctuating means increases an absolute value of the positive or negative electric field applied to the electronic equipment so as to generate first induction charging in the electronic equipment, then resets a potential of the first induction charging of the electronic equipment (resets to a ground potential), and further decreases the absolute value of the positive or negative electric field so as to generate second induction charging in the electronic equipment whose positive or negative sign is inverted from that of the first induction charging.

The apparatus for testing immunity of an electronic equipment against a fluctuating electric field, achieving the above-described object, is further characterized in that a plurality of the emission electrodes are disposed.

The apparatus for testing immunity of an electronic equipment against a fluctuating electric field, achieving the above-described object, is further characterized in that assuming that the EUT is a hexahedron, the apparatus includes: a first emission electrode disposed so as to face a first face of the hexahedron; and a second emission electrode disposed so as to face a second face of the hexahedron.

The apparatus for testing immunity of an electronic equipment against a fluctuating electric field, achieving the above-described object, is further characterized in that assuming that the EUT is a hexahedron, a plurality of the emission electrodes are disposed so as to face a first face of the hexahedron.

The apparatus for testing immunity of an electronic equipment against a fluctuating electric field, achieving the above-described object, is further characterized in that electric field emission surfaces of the plurality of emission electrodes are disposed side by side to form a single common electric field emission surface.

The apparatus for testing immunity of an electronic equipment against a fluctuating electric field, achieving the above-described object, is further characterized in that the electric field fluctuating means supplies voltages of different timings to the plurality of emission electrodes so that the respective emission electrodes apply the electric fields of different timings to the electronic equipment.

The apparatus for testing immunity of an electronic equipment against a fluctuating electric field, achieving the above-described object, is further characterized in that the electric field fluctuating means fluctuates the electric fields of the plurality of emission electrodes independently of each other so as to control a gradient of an electric field in a (local) space near the electronic equipment.

The apparatus for testing immunity of an electronic equipment against a fluctuating electric field, achieving the above-described object, is further characterized in that the plurality of emission electrodes are embedded in a sheet of an insulator.

The apparatus for testing immunity of an electronic equipment against a fluctuating electric field, achieving the above-described object, is further characterized in that: the emission electrode is a plate-shaped electrode; and a planar surface of the plate-shaped electrode is faced to the electronic equipment.

The apparatus for testing immunity of an electronic equipment against a fluctuating electric field, achieving the above-described obj ect, is further characterized in that: the emission electrode is a plate-shaped electrode; and a side surface of the plate-shaped electrode is faced to the electronic equipment.

The apparatus for testing immunity of an electronic equipment against a fluctuating electric field, achieving the above-described obj ect, is further characterized in that: the emission electrode is a rod-shaped electrode; and a side surface of the rod-shaped electrode extending in a longitudinal direction thereof is faced to the electronic equipment.

The apparatus for testing immunity of an electronic equipment against a fluctuating electric field, achieving the above-described object, is further characterized in that: the emission electrode includes a plurality of strip-shaped electric field emission surface pieces facing the electronic equipment; and the plurality of electric field emission surface pieces are arranged side by side to form a single electric field emission surface.

The apparatus for testing immunity of an electronic equipment against a fluctuating electric field, achieving the above-described object, is further characterized in that: the emission electrode includes a plurality of plate-shaped electrode pieces; and a planar surface of the plate-shaped electrode piece serves as the strip-shaped electric field emission surface piece.

The apparatus for testing immunity of an electronic equipment against a fluctuating electric field, achieving the above-described object, is further characterized in that: the emission electrode includes a plurality of plate-shaped electrode pieces; and a side surface of the plate-shaped electrode piece serves as the strip-shaped electric field emission surface piece.

The apparatus for testing immunity of an electronic equipment against a fluctuating electric field, achieving the above-described object, is further characterized in that: the emission electrode includes a plurality of rod-shaped electrode pieces; and a side surface of the rod-shaped electrode piece extending in a longitudinal direction thereof serves as the strip-shaped electric field emission surface piece.

The apparatus for testing immunity of an electronic equipment against a fluctuating electric field, achieving the above-described object, is further characterized in that: the emission electrode has a strip-shaped projection; and a tip of the strip-shaped projection serves as the strip-shaped electric field emission surface piece.

The apparatus for testing immunity of an electronic equipment against a fluctuating electric field, achieving the above-described object, is further characterized in that: the electric field fluctuating means includes a moving mechanism that changes a relative distance between the electronic equipment and the emission electrode; and an intensity and a gradient of the electric field are fluctuated by the change in the relative distance.

The apparatus for testing immunity of an electronic equipment against a fluctuating electric field, achieving the above-described object, is further characterized by including discharge detection means that detects a discharge phenomenon generated by the induction charging inside the electronic equipment.

The apparatus for testing immunity of an electronic equipment against a fluctuating electric field, achieving the above-described object, is further characterized by including synchronization control means that synchronizes a sensing timing of the discharge detection means with a fluctuating timing of the electric field by the electric field fluctuating means.

The apparatus for testing immunity of an electronic equipment against a fluctuating electric field, achieving the above-described object, is further characterized in that a high-resistance material is used as a material for the emission electrode.

The apparatus for testing immunity of an electronic equipment against a fluctuating electric field, achieving the above-described object, is further characterized in that a high-resistance rubber material is used for a wire for supplying a voltage to the emission electrode.

The present invention achieving the above-described object is a method for testing immunity of an electronic equipment against a fluctuating electric field characterized by: externally applying an electric field to an electronic equipment to be an equipment under test; EUT by means of an emission electrode; fluctuating an intensity and a gradient of the electric field applied to the electronic equipment so as to generate induction charging inside the electronic equipment; and testing operating characteristics of the electronic equipment with the induction charging.

The method for testing immunity of an electronic equipment against a fluctuating electric field, achieving the above-described object, is further characterized by: detecting a discharge phenomenon generated by the induction charging inside the electronic equipment; and testing operating characteristics of the electronic equipment with the discharge phenomenon.

The method for testing immunity of an electronic equipment against a fluctuating electric field, achieving the above-described object, is further characterized by fluctuating the intensity of the electric field applied to the electronic equipment by changing a voltage supplied to the emission electrode.

The method for testing immunity of an electronic equipment against a fluctuating electric field, achieving the above-described object, is further characterized by fluctuating the intensity and the gradient of the electric field applied to the electronic equipment by changing a relative distance between the emission electrode and the electronic equipment.

### Advantageous Effects of Invention

According to the present invention, it becomes possible to test malfunction due to a discharge phenomenon generated inside an electronic equipment, which cannot be tested with the conventional ESD testing apparatus.

### Brief Description of Drawings

FIG. 1 is a diagram showing experimental equipment used for verifying a discharge phenomenon detected in the present invention.
FIG. 2 is a graph showing a discharge waveform detected by the experimental equipment.
FIG. 3A is a front view showing a main unit of a testing apparatus according to a first embodiment of the present invention.
FIG. 3B is a top view showing the main unit of the testing apparatus according to the first embodiment of the present invention.
FIG. 3C is a side view showing the main unit of the testing apparatus according to the first embodiment of the present invention.
FIG. 3D is a diagram showing a control panel of the main unit of the testing apparatus according to the first embodiment of the present invention.
FIG. 4A is a graph showing a temporal fluctuation of an electric field waveform by the testing apparatus.
FIG. 4B is a graph showing a temporal fluctuation of induction charging generated in an electronic equipment by the testing apparatus.
FIG. 5A is a side view showing a testing apparatus according to a second embodiment of the present invention.
FIG. 5B is a top view showing the testing apparatus according to the second embodiment of the present invention.
FIG. 6A is a top view showing a testing apparatus according to a third embodiment of the present invention.
FIG. 6B is a side view showing the testing apparatus according to the third embodiment of the present invention.
FIG. 7A is a top view showing a testing apparatus according to a fourth embodiment of the present invention.
FIG. 7B is a graph showing voltage control timing waveforms of the testing apparatus according to the fourth embodiment of the present invention.
FIG. 8A is a diagram showing another configuration example of the testing apparatus.
FIG. 8B is a diagram showing another configuration example of the testing apparatus.
FIG. 8C is a diagram showing another configuration example of the testing apparatus.
FIG. 8D is a diagram showing another configuration example of the testing apparatus.
FIG. 9A is a side view showing a testing apparatus according to a fifth embodiment of the present invention.
FIG. 9B is a front view showing the testing apparatus according to the fifth embodiment of the present invention.
FIG. 10 is a diagram showing a testing apparatus according to a sixth embodiment of the present invention.
FIG. 11A is a diagram showing a testing apparatus according to a seventh embodiment of the present invention.
FIG. 11B is a diagram showing another configuration example of the testing apparatus.
FIG. 11C is a diagram showing another configuration example of the testing apparatus.
FIG. 11D is a diagram showing another configuration example of the testing apparatus.
FIG. 11E is a diagram showing another configuration example of the testing apparatus.

### Description of Embodiments

Exemplary embodiments of the present invention will be described in detail with reference to the drawings.

First of all, an experiment conducted by the present inventors will be described. This experiment verified whether or not induction charging of a component inside an electronic equipment is caused by the external application of a fluctuating electric field to the electronic equipment and leads to a discharge phenomenon inside the electronic equipment.

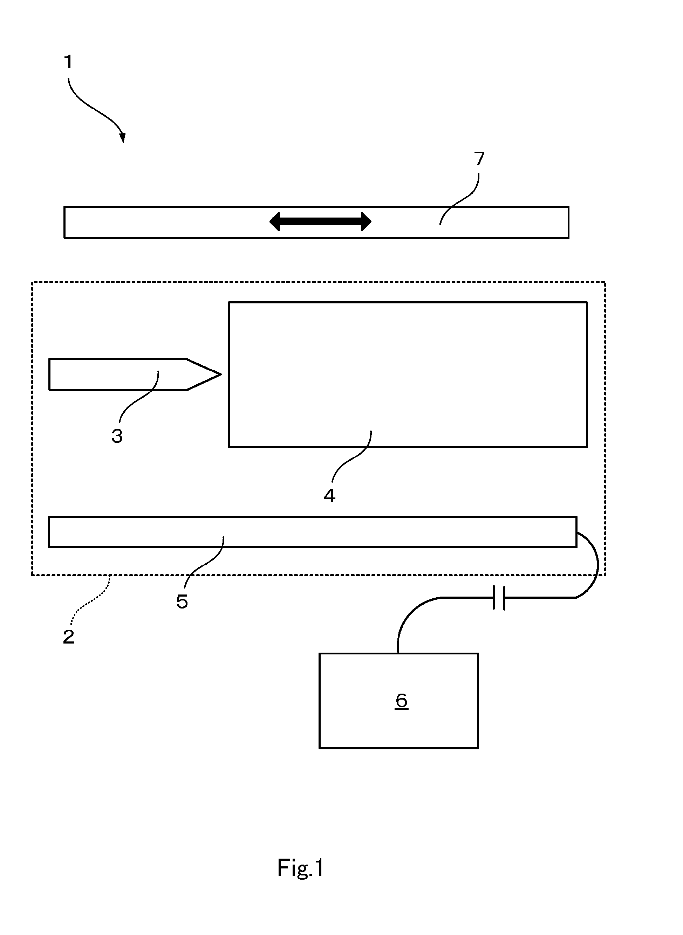

FIG. 1 shows experimental equipment 1 used for this verification. The experimental equipment 1 includes two small and large copper plates 3 and 4 disposed with a gap of 0.05 mm therebetween inside a plastic case 2. Note that the gap is not limited to 0.05 mm. Depending on a level of the induced voltage, it may be up to about 0.5 mm. However, since spark discharge is based on the Paschen's Law, a smaller gap is more preferable. This is because discharge occurs at a lower voltage when the gap is smaller with an atmospheric pressure being constant. Furthermore, a coaxial cable 5 including a probe portion (tip portion) of a differential probe and connected to an oscilloscope, is disposed in a parallel manner below the copper plates 3 and 4 with a distance of 20 mm therebetween inside the plastic case 2 so as to detect electromagnetic noise due to the discharge phenomenon generated between the copper plates 3 and 4. The separation distance is not limited to 20 mm. It may be greater as long as a sufficient received voltage can be obtained. Specifically, the detection bandwidth of this differential probe is set to 400 MHz, and a digital oscilloscope 6 is connected to the coaxial cable 5 as the differential probe output, so that a noise waveform from the discharge can be measured by the coaxial cable 5 and analyzed by the digital oscilloscope 6. Note that the positive side and the negative side of a signal input terminal at the tip of the differential probe are short-circuited with a very short copper wire so as to prevent the entering of an input signal. The small and large copper plates 3 and 4 are herein referred to as electrically floated conductors since they are not grounded to the earth and also not in contact with a conductor therearound.

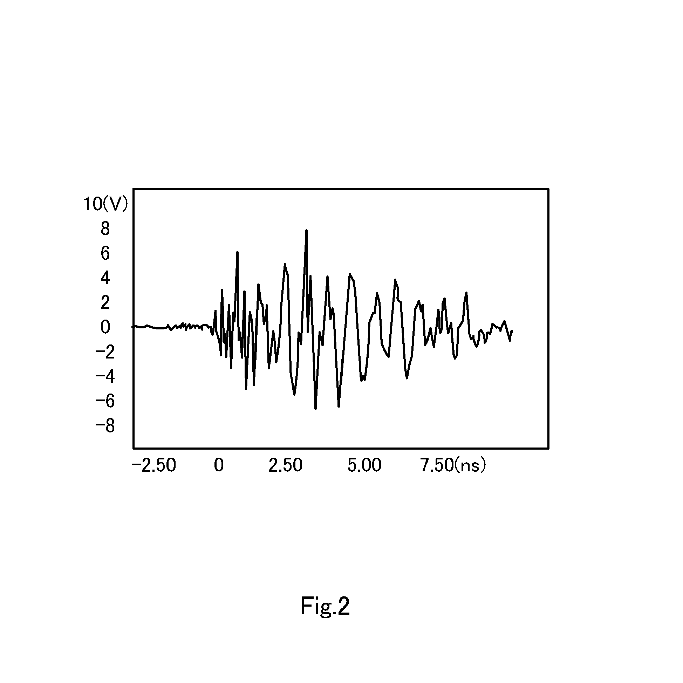

In this verification, a fluctuating electric field generated by moving an electrostatically charged plate 7 made of Teflon (registered trademark) or plastic from right to left or left to right by hand in the vicinity of an upper surface of the plastic case 2 was applied to the plastic case 2. A waveform detected by the digital oscilloscope 6 is shown in FIG. 2. Since this waveform has an oscillation with a cycle of a nanosecond or less and an amplitude of 10 V or greater, it can be concluded that discharge is being generated between the copper plates 3 and 4. Since the positive side and the negative side of the input section at the tip of the differential probe are short-circuited as mentioned above, no input signal has entered into the differential probe. Thus, a signal with such a large amplitude would not be generated essentially. Despite that, such a large noise signal is detected. This indicates that the induction charging of the copper plates 3 and 4 as the electrically floated conductors occurred along with the movement of the electrostatically charged plate 7 and dielectric breakdown was generated in the gap of 0.05 mm due to a potential difference caused by a difference in their sizes (dimensions and capacitances) and led to the occurrence of spark discharge. The spark discharge is discharge that ends in a short period of time at an extremely high speed. It emits a wideband electromagnetic wave (electromagnetic noise) containing a frequency component of several GHz or greater. This electromagnetic noise is received by the coaxial cable of the differential probe. The common mode signal is converted to a normal mode, and it is analyzed by the oscilloscope. In this manner, the waveform of FIG. 2 is obtained. Although not particularly shown in the figure, the electrostatically charged plate 7 made of Teflon (registered trademark) has a property to be charged negative easily, and the electrostatically charged plate 7 made of a plastic such as acrylic has a property to be charged positive easily.

If the electromagnetic noise due to discharge as shown in FIG. 2 is generated inside an electronic equipment, there is a sufficient possibility of causing malfunction in the case of an advanced IC. Specifically, just as the insight by the present inventors, it was found out that if a fluctuating electric field is applied externally to an electronic equipment protected by an insulating case, induction charging is generated inside the electronic equipment to cause discharge and thereby the malfunction of the electronic equipment.

In view of this, an apparatus for testing immunity against a fluctuating electric field according to an embodiment of the present invention to be described later is characterized in that: it tests whether or not the induction charging of the electrically floated conductor unintentionally existed inside an electronic equipment or electronic device to be tested is caused by a fluctuation in the electric field around the electronic equipment or electronic device, and leads to rapid discharge (spark discharge) between the electrically floated conductor and the conductor therearound and malfunction caused by the discharge; and it provides the countermeasures thereagainst.

For example, a main trouble regarded as a test object by the present invention is a phenomenon such that an electronic equipment malfunctions in spite of the absence of direct ESD with respect to the electronic equipment or indirect ESD around the equipment. In other words, it is a phenomenon such that malfunction is caused while an operator of the electronic equipment or an electrostatically charged object around the electronic equipment is not being in contact with the electronic equipment to be tested (no direct discharge is being generated on the electronic equipment). Electrostatic discharge that induces malfunction is generated inside the electronic equipment and generated moreover in a narrow gap with the adjacent metal conductor. Therefore, a frequency component contained in an emitted transient electromagnetic wave becomes very wide (several GHz or greater) and very strong. Thus, the electric field intensity thereof readily reaches the order of kV/m. As a result, malfunction is induced in an LSI (for example, a CPU or an IC) disposed in the vicinity of a discharge source or connected via a signal line passing through the vicinity of the discharge source, or the like. It can be considered that the detection and evaluation of such trouble and taking countermeasures thereagainst can be achieved only by a method using the fluctuating electric field immunity testing apparatus according to the present invention.

In a case where a CPU, an IC, or the like malfunctions, the restart thereof is typically conducted automatically so as to achieve automatic restoration thereof. In a case of an electronic equipment constituting part of a large-scale network, however, it interrupts a central computer via a communication line. If interrupts are requested by a large number of electronic unit, the processing capability of the entire system is significantly reduced, thereby leading to a possibility of causing a system failure. In particular, since the transient electromagnetic field emitted by this phenomenon is very strong, if all of electronic systememployed in a basic infrastructure with a multiple redundant configuration (an example thereof: a two-unit parallel operation) are caused to malfunction, there is consequently a possibility of directly leading to a serious accident.

In avionics or defensive equipments, heavy protective measures are taken against electromagnetic interference (EMI) due to a radar wave. However, the electric field intensity of an electromagnetic wave irradiation test (an example thereof: RTCA DO-160E) serving as the basis therefor is 600 V/m at a maximum (0.4 GHz to 18 GHz). This value corresponds to an electric field intensity obtained when irradiated from a pulse radar of 1000 kW (1 MW) placed away from the equipment with a distance of 10 m. The method we propose herein can generate an electric field intensity exceeding 1 kV/m inside an equipment and makes it possible to test the immunity thereagainst. Moreover, according to the present invention, none of an expensive and elaborate anechoic chamber, a high-power power amplifier, a radiation antenna, and the like are necessary. According to the verification by the present inventors, in a case where the discharge gap is equal to about 0.05 mm, it was foundout that: a spectrumdistribution observed by a spectrum analyzer well exceeds 18 GHz; the rise time of an impulse current to drive the electrically floated conductor (tiny dipole) occurs very short(estimated to be less than 40 ps) ; and the impulse current has a large amplitude (the order in a range of from several tens of amperes to 100 A although it depends on the charge amount thereof).

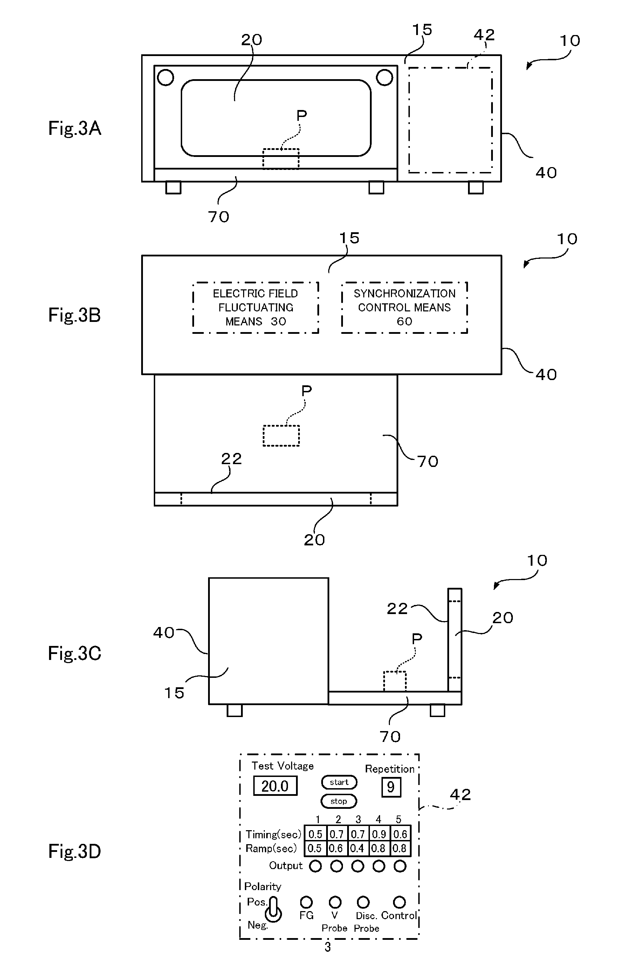

Next, with reference to FIGS. 3A to 3D and the subsequent figures, a description will be given of a fluctuating electric field immunity test apparatus (hereinafter, a testing apparatus) 10 of the first embodiment for testing the immunity of an electronic equipment by forcibly inducing a particular discharge phenomenon as described above within the electronic equipment. FIG. 3A shows a front view of the testing apparatus, FIG. 3B shows a top view of the testing apparatus, FIG. 3C shows a side view of the testing apparatus, and FIG. 3D shows a control panel on a main unit of the testing apparatus.

The testing apparatus 10 includes: a main unit 15; an emission electrode 20; electric field fluctuating means 30; a casing 40; discharge detection means (will be described later); synchronization control means 60; and a placement table 70. The electric field fluctuating means 30, the discharge detection means (will be described later), and the synchronization control means 60 are accommodated inside the casing 40 in the main unit 15.

The emission electrode 20 externally applies one of positive and negative electric fields to an electronic equipment P to be an equipment under test; EUT without being in contact therewith. The emission electrode 20 has a so-called plate shape (board shape), and a plantar surface thereof serves as an electric field emission surface 22. The emission electrode 20 is fixed to the placement table 70 in a standing state so that the electric field emission surface 22 faces a side surface of the electronic equipment P.

The placement table 70 is horizontally disposed so as to be protected from a side surface of the main unit 15, and at least the upper surface thereof is formed by an insulating material. The electronic equipment P is placed at the center of the placement table 70.

Here, the electric field fluctuatingmeans 30 is a voltage control device and contained inside the casing 40. The electric field fluctuating means 30 fluctuates the intensity of the electric field generated from the emission electrode 20 without changing the polarity thereof by changing a direct-current voltage supplied to the emission electrode 20. As a result, the intensity of the electric field to be applied to the electronic equipment P during the test can be fluctuated over time without changing the polarity thereof. In a case where an electrically floated conductor (ungrounded conductor) exists inside the electronic equipment P, induction charging occurred on this electrically floated conductor when the electric field applied to the electronic equipment P is fluctuated. By this forcible induction charging occurring inside the electronic equipment P, the testing apparatus 10 can verify operating characteristics such as whether or not there exists a structure that generates spark discharge inside or around the electronic equipment P and whether or not the electronic equipment P thereby malfunctions. Specifically, in a case where another conductor is disposed so as to be adj acent to the electrically floated conductor inside the electronic equipment P, the discharge phenomenon may be occurred therebetween as shown in the above-described verification example. By proving an environment that forcibly generates such discharge, the presence or absence of the discharge is verified and immunity against noise is tested at the same time.

A control panel 42 (see FIG. 3D) is provided on the casing 40 of the main unit 15. The control panel 42 includes: an emitted voltage setting section (Test Voltage) ; a test start button (Start) ; a test stop button (Stop) ; a repetition setting section (Repetition) for setting the number of tests (the number of voltage applications) within a range of from 0 to 9; an application time setting section (Timing) for setting application timings (delay timings) of voltages to be supplied to respective electrodes in the case of a multiple-electrode specification within a range of from 0.1 to 1 second; a ramp setting section (Ramp) for setting application ramps of those voltages within a range of from 0.1 to 1 second; a connector section (Output) to which wires for supplying voltages to the respective electrodes are connected; a polarity setting section (Polarity) for switching a polarity of a high-voltage electric field; a terminal (FG) for supplying a ground potential to an electronic instrument or a test head jig; a coupling connector (Disc. Probe) for a discharge detection probe; a coupling connector (V Probe) for a charged potential detection probe; a coupling connector (Control) for controlling a multiaxis robot that moves the emission electrode (will be described in detail in the second embodiment); and the like.

The emission voltage setting section (Test Voltage) sets an application voltage within a range of from 0 to -25 kV or a range of from 0 to +25 kV.

The test start button (Start) and the test stop button (Stop) are buttons used for manually starting or stopping a test. In a case where the set number in the repetition setting section (Repetition) is 0, the test is repeatedly performed during a time period after pressing of the test start button (Start) until pressing of the test stop button (Stop). In a case where the number of tests (the number of voltage applications) is set within a range of from 1 to 9, the test is automatically stopped when the test number is completed.

A discharge detection probe (not shown) to be the discharge detection means is connected to the connector (Disc. Probe). The discharge detection probe performs detection by receiving and amplifying an electromagnetic wave emitted by discharge. And then, the discharge detection probe announces the detection to a user by alarm sounds or LED lights. Note that there may be incorporated functions to transmit the detection signal to the main unit 15 and record it as a history. A charging detection antenna (not shown) is connected to the connector (V Probe) for a charged potential detection probe. The charging detection antenna performs charging detection by sensing a fluctuation of an electric field, amplifying it, and then performing a signal processing thereto. Note that these functions to detect discharge and to detect a charged potential can be incorporated in the main unit 15.

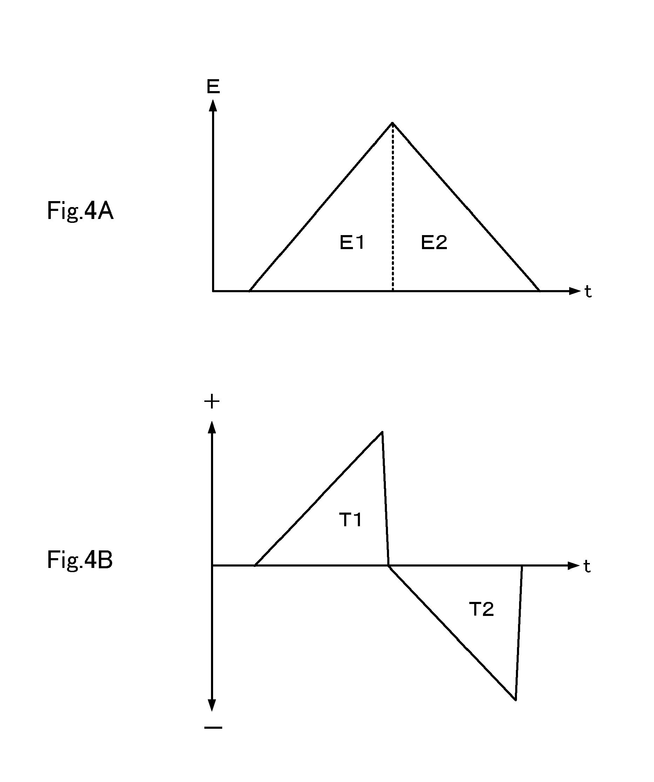

FIG. 4A schematically shows a temporal fluctuation in an electric field emitted from the emission electrode 20 by the electric field fluctuating means 30. FIG. 4B schematically shows a temporal fluctuation in induction charging acting upon the electronic equipment P.

First, the electric field fluctuating means 30 gradually increases the absolute value of the positive or negative direct-current voltage supplied to the emission electrode 20. As a result, the emission electrode 20 produces an electric field E1 to be an increasing region. Here, the electric field E1 is set to be positive. As a result, gradually-increasing positive induction charging T1 is generated in the electronic equipment P. By means of this operation, discharge and malfunction are tested in a case where the positive first induction charging T1 is generated in the electronic equipment P.

Thereafter, the first induction charging T1 of the electronic equipment P is grounded while maintaining the electric field E1 of the emission electrode 20 so as to reset the potential once. Furthermore, the absolute value of the positive or negative voltage supplied to the emission electrode 20 is reduced to 0 V so that the emission electrode 20 produces an electric field E2 as a decreasing region. Consequently, gradually-increasing negative second induction charging T2, whose sign is inverted from the first induction charging T1, is generated in the electronic equipment P. By means of this operation, discharge and malfunction are tested in a case where the negative second induction charging T2 is generated in the electronic equipment P.

In other words, according to this electric field fluctuating means 30, the positive and negative induction charging phenomena can be generated in the electronic equipment P only by supplying either positive or negative single polarity voltage to the emission electrode 20. Thus, it is possible to simplify the instrument configuration.

Incidentally, the electric field fluctuating means 30 can adjust the voltage (emitted voltage) to the emission electrode 20 within a range of from -25 kV to +25 kV in the present embodiment. Thus, it is possible to produce both the positive and negative electric fields. Moreover, a repetition period of the voltage supply can be adjusted within a range of from 2 seconds/cycle to 10 seconds/cycle. An applied electric field ramp can be controlled in a range of from 0.1 second to 1 second.

Although particularly not shown in the figure, it is preferable that the reset of the induction charging in the electronic equipment P be forcibly performed by preliminarily connecting the earth terminal (FG) capable of switching between ON and OFF of a grounded state to the electronic equipment P and switching the ON and OFF of the earth terminal by the electric field fluctuating means 30. On the other hand, if the intensity (absolute value) of the electric field applied to the electronic equipment P reaches some level (a voltage determined by the gap between adjacent conductors and by the other conditions), spark discharge occurs. Thus, in a case where the spark discharge of the electronic equipment P is detected by the discharge detection means, it maybe controlled so as to stop the voltage increase and switch to decrease. By doing so, the ON/OFF switch of the earth terminal can be omitted.

The synchronization control means 60 synchronizes the sensing timing of the discharge detection means with the electric field fluctuating timing by the electric field fluctuating means 30. This is because an electric field needs to be repeatedly applied to the electronic equipment P in a single test so as to detect the presence or absence of the discharge state thereof, or the like. Here, the number of repetitions for the electric field application can be selected within a range of from 1 to 9, or a pattern such that a continuous application is performed until forcibly stopped can be selected.

Thus, using the testing apparatus 10 of the first embodiment, it is possible to simulate a state as if what is called an electrostatically charged body is externally moved closer to or away from the electronic equipment P. As a result, it becomes possible to test the malfunction of the electronic equipment P on the basis of a phenomenon such that clothing or a human body charged with static electricity is moved closer to or away from the electronic equipment P, for example. In particular, the testing apparatus 10 makes it possible to extremely simplify the device configuration and realize a stable test since the state as if the electrostatically charged body is moved closer thereto or away therefrom is virtually created by increasing or decreasing the electric field intensity generated from the emission electrode 20.

Furthermore, unlike direct discharge by means of the ESD gun as in a conventional technique, it is possible by using the testing apparatus 10 to verify a discharge phenomenon occurred inside the electronic equipment P due to a fluctuation of the external electrostatic field. Thus, it becomes possible to guarantee an operation assuming the movement of a user (a person who holds an electrostatic field) operating the electronic equipment P and therefore to further enhance the safety of the electronic equipment P.

In the specific test, the immunity of the electronic equipment P against the electric field may be verified by appropriately utilizing information such as the number of discharge phenomena occurred inside the electronic equipment P by the discharge detection means, the magnitude of the amplitude when a discharge waveform is detected (noise intensity), and whether or not the electronic equipment P is actually causing malfunction.

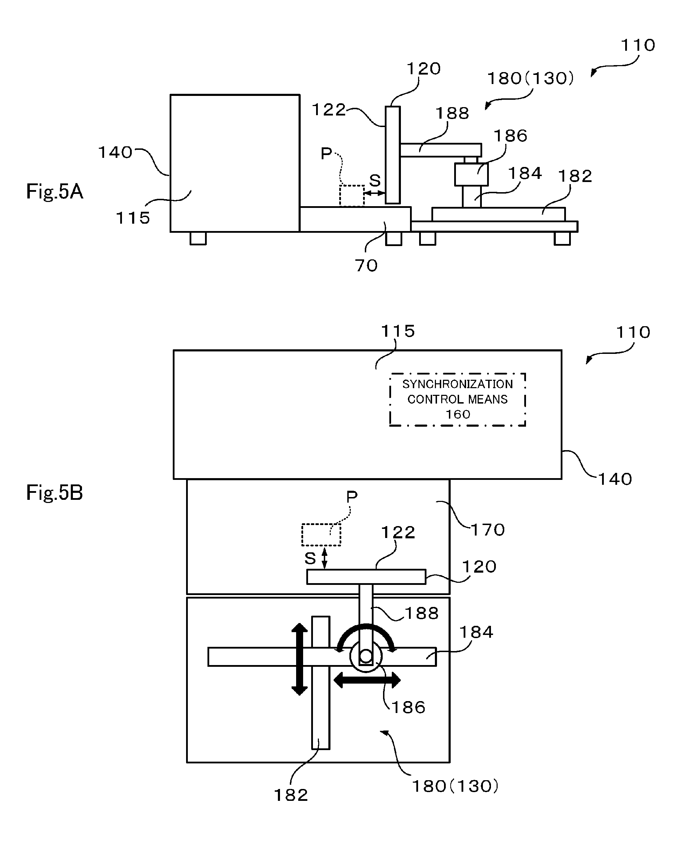

Next, a testing apparatus 110 by the second embodiment will be described with reference to FIGS. 5A and 5B. FIG. 5A is a side view of the testing apparatus 110, and FIG. 5B is a top view thereof. The last two digits of reference numerals used in the illustration and description for the testing apparatus 110 correspond to the reference numerals of the testing apparatus 10 in the first embodiment so that redundant descriptions can be omitted. Here, points differing from those of the first embodiment will be described mainly.

The testing apparatus 110 includes, as electric field control means 130, a moving mechanism 180 for changing a relative distance S between the electronic equipment P and an emission electrodes 120. By changing the relative distance S, an electric field intensity applied to the electronic equipment P is fluctuated.

Specifically, the moving mechanism 180 includes: an X-axis guide 182 disposed in a horizontal direction; a Y-axis guide 184 disposed on the X-axis guide 182; a Z-axis rotary motor 186 disposed on the Y-axis guide 184; and an arm member 188 held by the Z-axis rotary motor 186. The emission electrode 120 is fixed to a tip of the arm member 188. Note that a Z-axis guide for further controlling the movement in the height direction (Z direction) can be further added to achieve triaxial movements.

The X-axis guide 182 conveys the Y-axis guide 184 in the X-axis direction, and the Y-axis guide 184 conveys the Z-axis rotary motor 186 in the Y-axis direction. The Z-axis rotary motor 186 rotates the arm member 188. The combination of these motions allows the emission electrode 120 to perform X-Y planar moving and Z-axis rotations as desired. Synchronization control means 160 synchronizes the sensing timing of the discharge detection means with the movement timing by the moving mechanism 180.

According to the testing apparatus 110, it is possible to move an electrostatically charged body closer to or away from the electronic equipment P in various directions and with various angles. As a result, an electric field applied to the electronic equipment P can be fluctuated. This allows simulating a state as if a person wearing easily-charged clothing such as a chemical fiber passes through an automatic ticket gate, for example. In other words, the testing apparatus 110 makes it possible to check whether or not malfunction occurs by simulating various electric field fluctuation patterns so as to cause induction charging inside the electronic equipment P.

Although there was illustrated here the case where the electric field intensity applied to the electronic equipment P is fluctuated by a change in the relative distance S by means of the moving mechanism 180, the present invention is not limited thereto. For example, more advanced electric field control can be achieved by changing a supply voltage to the emission electrode 120 as shown in the first embodiment in addition to the change in the relative distance S. Also, although there was illustrated here the case where the relative distance S between the electronic equipment P and the emission electrode 120 is changed by moving the emission electrode 120 by means of the moving mechanism 180, it is obviously possible to change the relative distance S between the electronic equipment P and the emission electrode 120 by moving the electronic equipment P side by means of the moving mechanism 180 or the like. Furthermore, it is also possible to move both of the electronic equipment P and the emission electrode 120 so as to change the relative distance S therebetween.

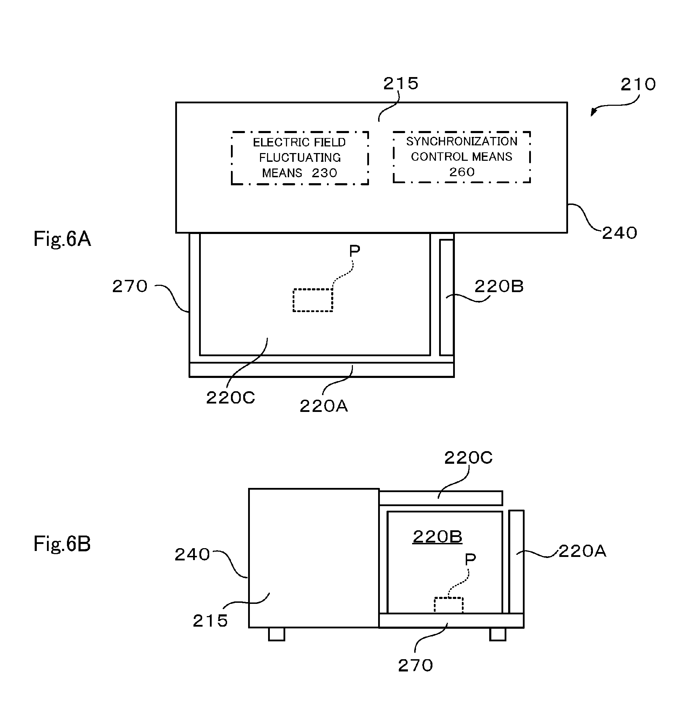

Next, a testing apparatus 210 according to the third embodiment will be described with reference to FIGS. 6A and 6B. FIG. 6A is a top view of the testing apparatus 210, and FIG. 6B is a side view thereof. The last two digits of reference numerals used in the illustration and description for the testing apparatus 210 correspond to the reference numerals of the testing apparatus 10 in the first embodiment so that redundant descriptions can be omitted. Here, points differing from those of the first embodiment will be described mainly.

In the testing apparatus 210, there are disposed first to third emission electrodes 220A to 220C. Specifically, assuming that the electronic equipment P is a hexahedron, the first emission electrode 220A is disposed so as to face a first face of the hexahedron, the second emission electrode 220B is disposed so as to face a second face forming a right angle with the first face of the hexahedron, and the third emission electrode 220C is disposed so as to face a third face forming right angles with both of the first face and the second face of the hexahedron. By doing so, the three faces of the hexahedron are tested together with a single testing step. Therefore, by inverting the electronic equipment P, the testing of all the six faces can be completed with two testing steps. Thus, the test efficiency can be improved.

Furthermore, according to the testing apparatus 210, it is possible to verify an electric field fluctuation such as to move from the first emission electrode 220A to the second emission electrode 220B side, for example, by applying DC voltages to the first to third emission electrodes 220A to 220C with shifted timings (shifted phases). It is also possible to verify a state as if electrostatically charged bodies are moved closer to or away from the electronic equipment P in a plurality of directions at the same time by simultaneously supplying voltages to the first to third emission electrodes 220A to 220C.

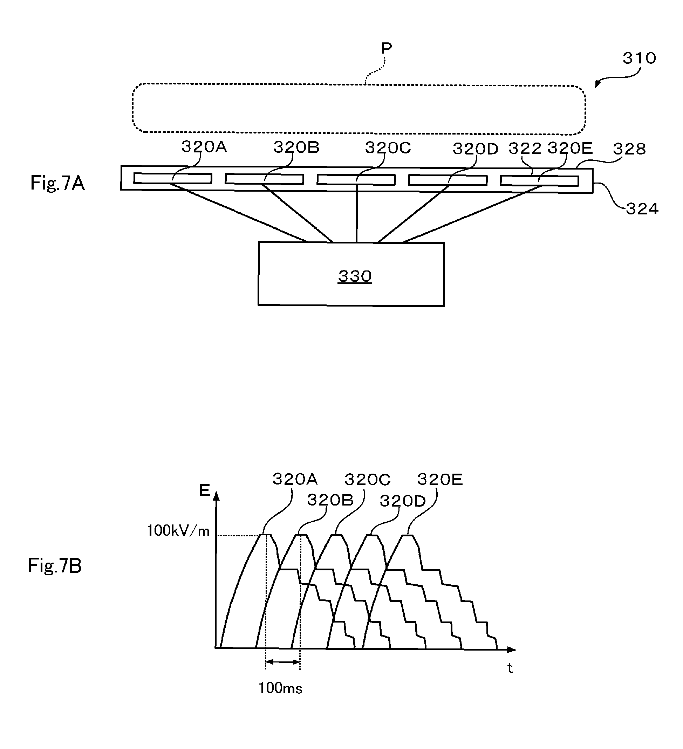

Next, a testing apparatus 310 according to the fourth embodiment will be described with reference to FIG. 7. FIG. 7A is a top view of the testing apparatus 310, and FIG. 7B is a graph showing voltage and timing waveforms controlled by the testing apparatus 310. The last two digits of reference numerals used in the illustration and description for the testing apparatus 310 correspond to the reference numerals of the testing apparatus 10 in the first embodiment so that redundant descriptions can be omitted. Here, points differing from those of the first embodiment will be described mainly.

In the testing apparatus 310, all of first to fifth emission electrodes 320A to 320E are disposed so as to face one surf ace of the electronic equipment P. Furthermore, these first to fifth emission electrodes 320A to 320E are embedded in a sheet of an insulator 324. Thus, electric field emission surfaces 322 of the plurality of emission electrodes 320A to 320E lie in a row to form a single common electric field emission surface 328. Since a potential can be changed partially on the common electric field emission surface 328, it is possible to form an electric field gradient adjacent to the electronic equipment P.

The insulator 324 has a sheet shape made of a material such as nylon. The first to fifth emission electrodes 320A to 320E inside the insulator 324 preferably employ a flexible and high-resistance material such as a conductive rubber. As a result, the first to fifth emission electrodes 320A to 320E are insulated from each other.

Electric field fluctuating means 330 controls supply voltages to the first to fifth emission electrodes 320A to 320E independently of each other. As shown in FIG. 7B, voltages are supplied to the first to fifth emission electrodes 320A to 320E with their timings being shifted from each other. As a result, the first to fifth emission electrodes 320A to 320E can apply different electric fields at different timings to the electronic equipment P. In other words, an electric field moving from the first emission electrode 320A toward the fifth emission electrode 320E in that order along the electric field emission surface 322 can be applied to the electronic equipment P. Note that supplied voltage waveforms preferably overlap between adjacent emission electrodes. As a result, it becomes possible to create a smoothly-moving electric field.

In a case where the electronic equipment P is an automatic ticket gate, for example, the first to fifth emission electrodes 320A to 320E are disposed on a side surface of the automatic ticket gate so as to apply a fluctuating electric field thereto. As a result, it allows simulating a state as if electrostatically charged human walk through the side surfaces of the automatic ticket gates.

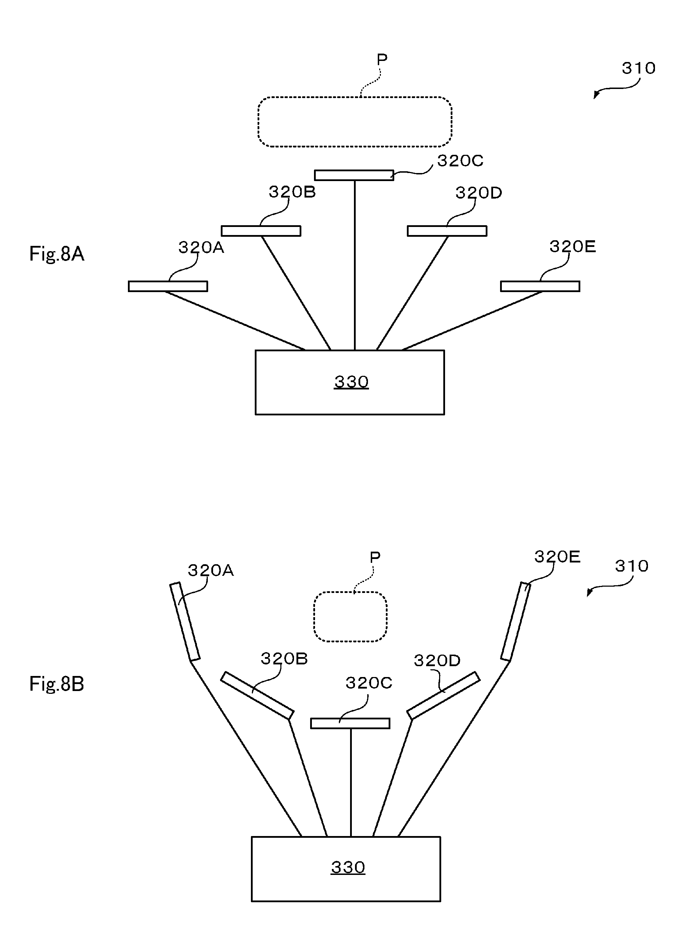

Although there was illustrated here the case where the first to fifth emission electrodes 320A to 320E are on a straight line, they may be located in a V-shape such that the third emission electrode 320C is closest to the electronic equipment P and the first and fifth emission electrodes 320A and 320E are farthest away from the electronic equipment P as shown in FIG. 8A, for example. By controlling voltages as in FIG. 7B under such a state, it becomes possible to simulate an environment such that an electric field moves closer to the electronic equipment P and then away from the electronic equipment P. In an opposite manner, it is also possible to locate the first to fifth emission electrodes 320A to 320E so as to surround the electronic equipment P along a V-shape or an arc shape.

Moreover, since the peripheries of these first to fifth emission electrodes 320A to 320E are covered with an insulating material, a test can be performed with those electrodes being attached to the electronic equipment P. Such attachment makes it possible to strengthen an applied electric field even at a lower voltage.

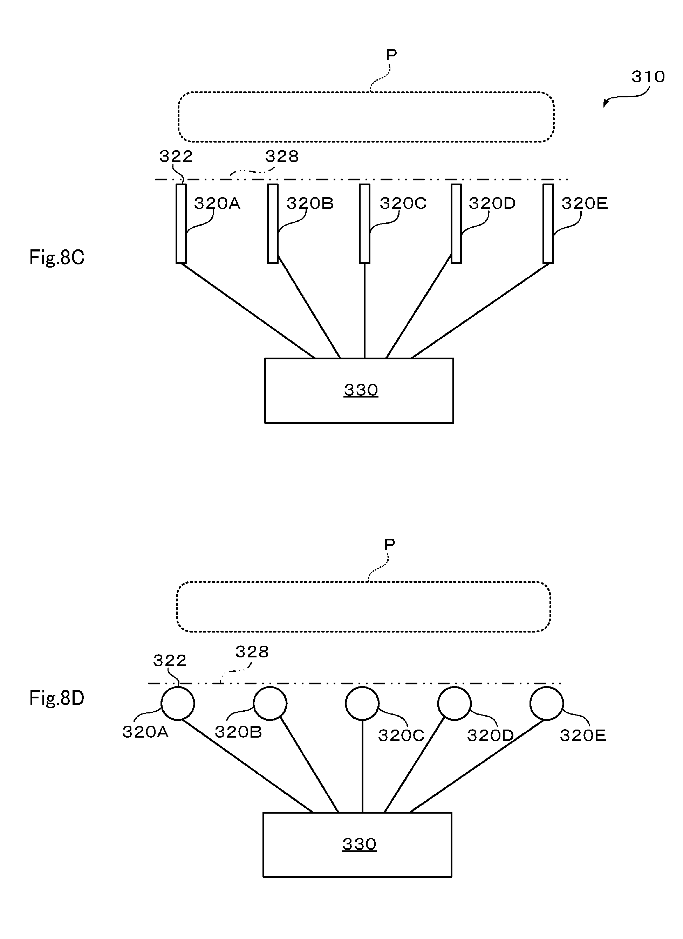

Furthermore, there was illustrated here the case where each of the first to fifth emission electrodes 320A to 320E has a plate shape (board shape), and planar surfaces thereof serve as the electric field emission surfaces 322 and face the electronic equipment P. However, it is also preferable that side edge of the first to fifth emission electrodes 320A to 320E be used as the electric field emission surfaces 322 so as to face the electronic equipment P as shown in FIG. 8C, for example. The plurality of electric field emission surfaces 322 form a single common electric field emission surface 328. As compared to the planar surface of the plate to be an electrode, the side surface of the plate can increase the density of electric force lines. Thus, it becomes possible to efficiently generate induction charging in the electronic equipment P. Although not shown in the figures, it is also preferable to round corner portions of the peripheries of the plates forming the first to fifth emission electrodes 320A to 320E. This is because if any sharp corner portion exist on the emission electrodes, corona discharge is more likely to occur therefrom. There are several problems resulting from the occurrence of the corona discharge. One of such problems is that the corona discharge lowers the potential on the emission electrode and thereby lowers the electric field emissionperformance. Next, there is problem that the discharge emits ozone and thereby corrodes and oxidizes the circumference thereof. Furthermore, there is a problem that the corona discharge emits discharge noise. As compared to the spark discharge generated by the induced ESD to be detected with the apparatus of the present invention, the radiated noise by the corona discharge has much narrow frequency spectrum and also the low noise level.

Furthermore, although there was illustrated here the case where each of the first to fifth emission electrodes 320A to 320E has a plate shape (board shape), it is also preferable that the emission electrodes 320A to 320E be rod-shaped electrodes and their side surfaces extending in the longitudinal direction thereof be faced to the electronic equipment P as shown in FIG. 8D. Since the side surface of the rod-shaped electrode can increase the density of electric force lines, it becomes possible to efficiently generate induction charging in the electronic equipment P.

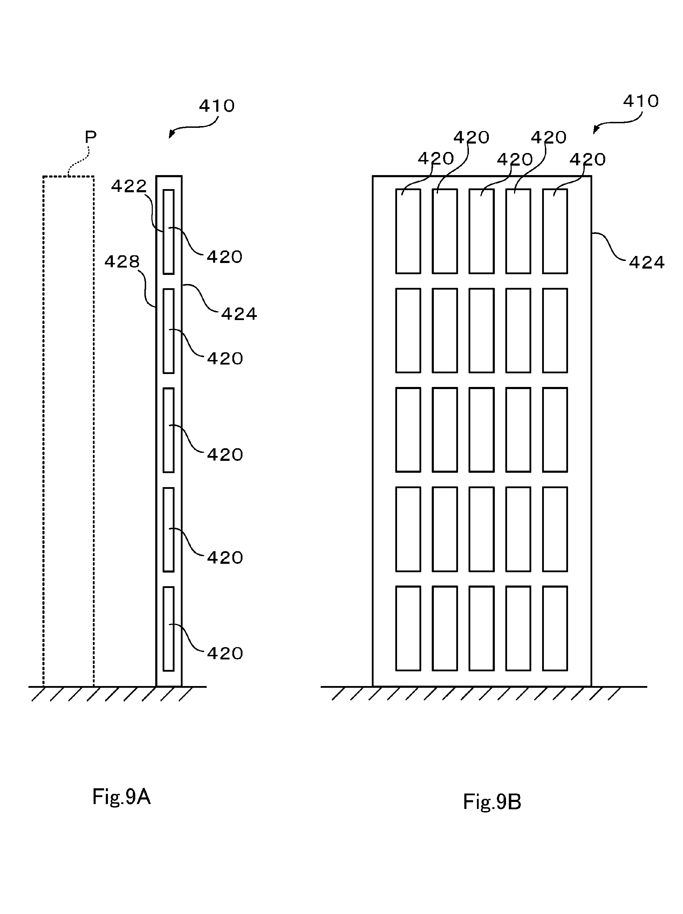

Next, a testing apparatus 410 according to the fifth embodiment will be described with reference to FIGS. 9A and 9B. FIG. 9A is a side view of the testing apparatus 410, and FIG. 9B is a front view of the testing apparatus 410. The last two digits of reference numerals used in the illustration and description for the testing apparatus 410 correspond to the reference numerals of the testing apparatus 10 in the first embodiment so that redundant description can be omitted. Here, points differing from those of the first embodiment will be described mainly.

In the testing apparatus 410, a total of 25 emission electrodes 420 are disposed in a matrix form so as to face one surface of the electronic equipment P. Furthermore, these emission electrodes 420 are embedded in a sheet of an insulator 424. Thus, electric field emission surfaces 422 of the plurality of emission electrodes 420 are in a line to form a single common electric field emission surface 428. Since potentials can be changed in a matrix form over the entire area of the common electric field emission surface 428 in the face direction, it is possible to form any electric field gradient in the two-dimensional direction as desired close to the electronic equipment P.

Fluctuating means of electric field, which is not particularly shown in the figure, independently controls supply voltages to each of these emission electrodes 420. Specifically, voltages are controlled so that an electric field moves in a vertical direction along the face direction of the electric field emission surface 422.

In a case where the electronic equipment P is an air traffic control panel, for example, the testing apparatus 410 is disposed in front of the control panel and applies thereto an electric field that fluctuates in the vertical direction. As a result, it becomes possible to simulate a state as if an electrostatically charged operator is operating the control panel with standing up from and sitting down on a chair.

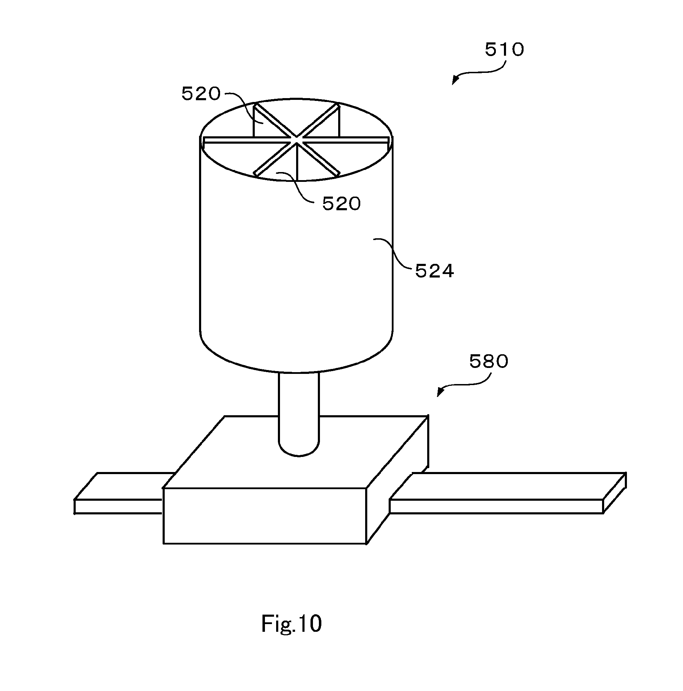

Next, a testing apparatus 510 according to the sixth embodiment will be described with reference to FIG. 10. The last two digits of reference numerals used in the illustration and description for the testing apparatus 510 correspond to the reference numerals of the testing apparatus 10 in the first embodiment so that redundant description can be omitted. Here, points differing from those of the first embodiment will be described mainly.

The testing apparatus 510 has a structure such that a cylindrical emission electrode 520 moves in a straight line by a self-propelled moving mechanism 580. The emission electrode 520 is configured by crisscrossing two aluminum plate-shaped electrodes to form a vane shape. The circumference of the emission electrode 520 is surrounded by a cylinder 524 made of an insulating material such as ABS resin. By making the emission electrode 520 autonomously run by the moving mechanism 580, it is possible to test an influence on an electronic instrument having a horizontally-elongated structure, for example, when the emission electrode 520 is moved along the longitudinal direction thereof.

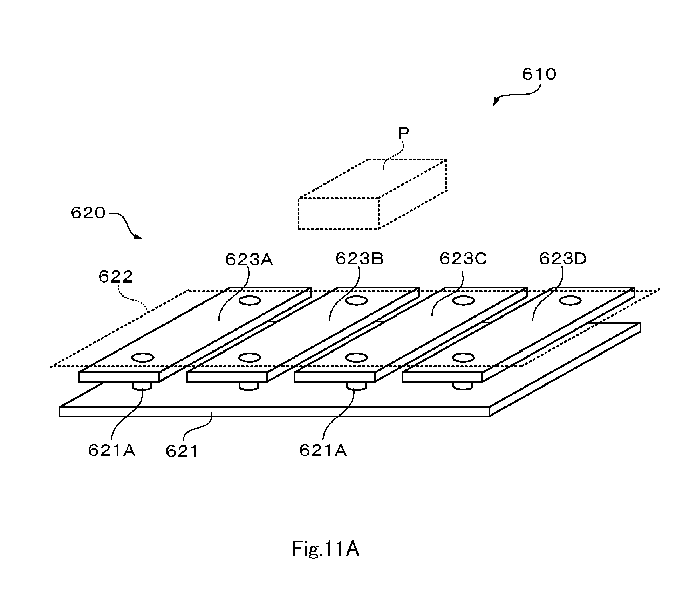

Next, a testing apparatus 610 according to the seventh embodiment will be described with reference to FIG. 11A. Since the testing apparatus 610 has features in the shape of an emission electrode 620, the emission electrode 620 will be exclusively described in detail.

The emission electrode 620 of the testing apparatus 610 includes: a base electrode plate 621; and a plurality of (herein, four) plate-shaped electrode pieces 623A to 623D fixed to the base electrode plate 621 via spacers 621A with a space therebetween. The four plate-shaped electrode pieces 623A to 623D are plates each having an elongated strip shape. They are disposed side by side, and planar surfaces thereof face the electronic equipment P. Moreover, these plate-shaped electrode pieces 623A to 623D are electrically conducted. In other words, the respective planar surfaces of the plate-shaped electrode pieces 623A to 623D serve as electric field emission surface pieces. These electric field emission surface pieces lie in a row to form a single electric field emission surface 622 having the same potential. By disposing the plurality of plate-shaped electrode pieces 623A to 623D above the single emission electrode 620 as described above, it is possible to effectively use high-density lines of electric force emitted from the peripheries of the plate-shaped electrode pieces 623A to 623D. Thus, it becomes possible to efficiently generate induction charging in the electronic equipment P.

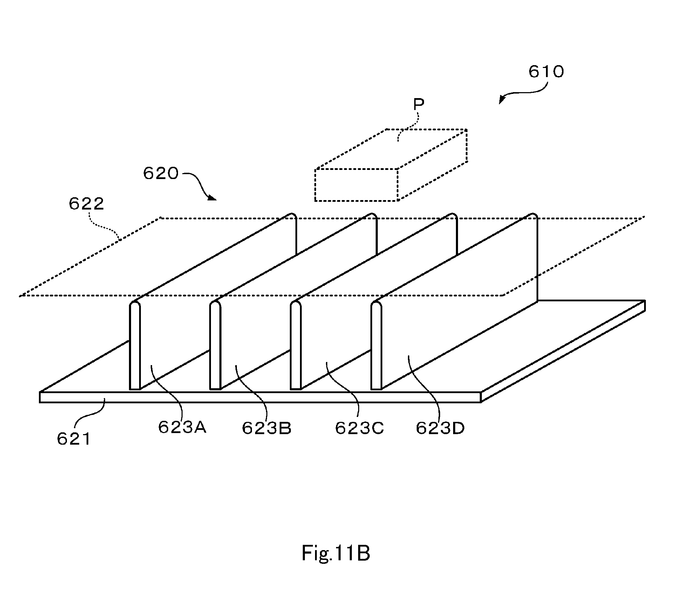

Alternatively, as shown in FIG. 11B, for example, it is further preferable to arrange the plate-shaped electrode pieces 623A to 623D vertically on the base electrode plate 621. By doing so, respective side surfaces of the four plate-shaped electrode pieces 623A to 623D can be set to face the electronic equipment P. As a result, the respective side surfaces of the plate-shaped electrode pieces 623A to 623D serve as electric field emission surface pieces. These electric field emission surface pieces lie in a row to form a single electric field emission surface 622 having the same potential. In comparison with the example of FIG. 11A, the side surfaces allowing higher-density lines of electric force are faced to the electronic equipment P. Thus, it becomes possible to more efficiently generate induction charging in the electronic equipment P. Here, there is illustrated a case where the side surfaces of the plate-shaped electrode pieces 623A to 623D are rounded. By rounding off the side surfaces in this manner, corona discharge can be suppressed. If the corner of the side surface has a sharp edge, on the other hand, corona discharge is more likely to occur therefrom. The problems of the corona discharge are as described above.

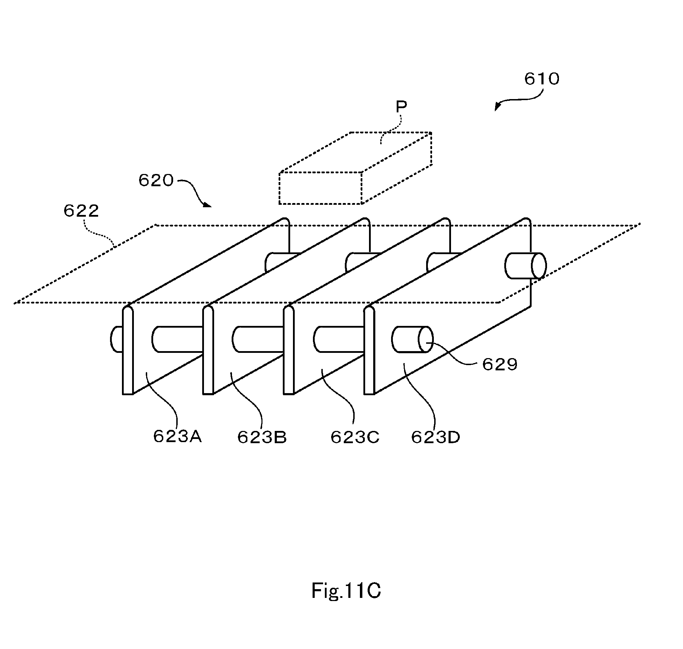

There was illustrated in FIG. 11B the case where the plate-shaped electrode pieces 623A to 623D are arranged vertically on the base electrode plate 621. However, it is also preferable that the plurality of plate-shaped electrode pieces 623A to 623D be skewered with a rod or plate spacers 629 as shown in FIG. 11C.

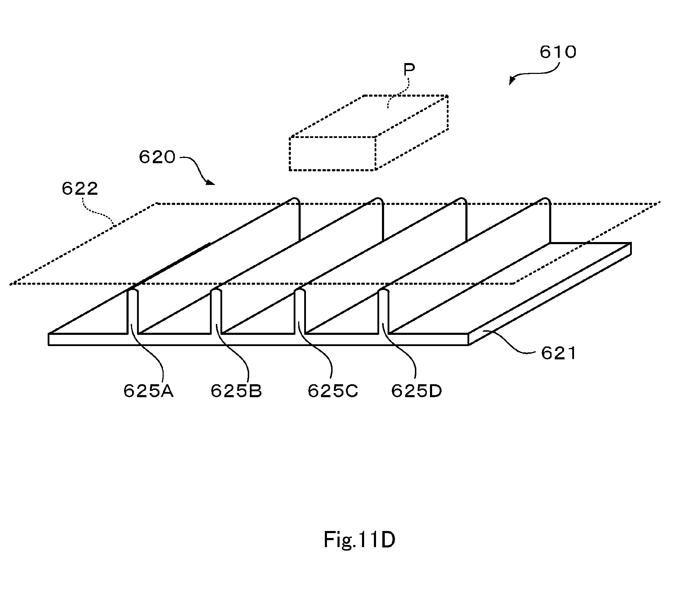

Furthermore, although there was illustrated in FIG. 11B the case where the base electrode plate 621 and the plate-shaped electrode pieces 623A to 623D are separate members, they may be integrally formed. Specifically in this case, it can be recognized as a state in which strip-shaped projections 625A to 625D are formed with respect to the base electrode plate 621 as shown in FIG. 11D. Respective tips of the strip-shaped projections 625A to 625D serve as strip-shaped electric field emission surface pieces. These strip-shaped electric field emission surface pieces lie in a row to form a single electric field emission surface 622 of the same potential.

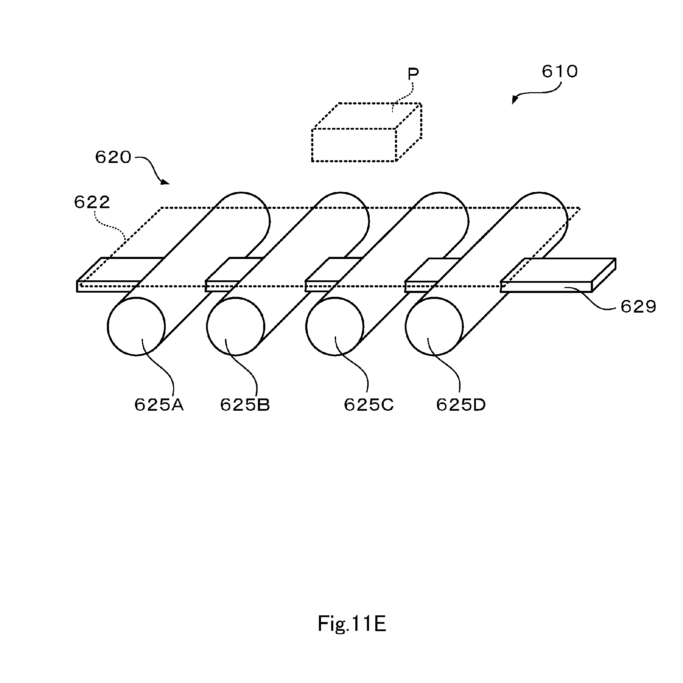

In each of FIGS. 11A to 11C, there was illustrated the case where the emission electrode 620 includes the plurality of plate-shaped electrode pieces 623A to 623D. However, it is also preferable that the emission electrode 620 include a plurality of rod-shaped electrode pieces 625A to 625D and side surfaces of the respective rod-shaped electrode pieces 625A to 625D extending in the longitudinal direction thereof be faced to the electronic equipment P as shown in FIG. 11E. By doing so, the side surfaces of the respective rod-shaped electrode pieces 625A to 625D serve as strip-shaped electric field emission surface pieces. These electric field emission surface pieces lie in a row to form a single electric field emission surface 622 of the same potential. Note that the plurality of rod-shaped electrode pieces 625A to 625D are preferably skewered with the spacers 629.

In the above-described first to seventh embodiments, a high-resistance material is preferably used as a material for the emission electrode, for example, although materials for the emission electrode are not particularly limited. As the high-resistance material, a material having a volume resistivity of 100 (kΩ·m) or greater, for example, is preferably selected, and ceramic or the like is preferred. Moreover, as the connection line for supplying a voltage to the emission electrode, it is desirable to employ not a typical metal wire (copper wire) but a high-resistance wire (for example, a high-resistance wire made of a rubber, or the like) . By selecting such a high-resistance material, it is possible to suppress electromagnetic field radiation due to the generation of a rapid current at the time of a voltage application while applying a sufficient electric field to the electronic equipment P. As a result, it is possible to avoid the mix-up with the conventional ESD test using the ESD gun. In other words, a discharge phenomenon inside the electronic equipment P, as sought for by the present invention, can be induced actively. It also leads to improved equipment safeness such that electrification can be prevented even if an operator accidentally touches the emission electrode.

Moreover, in the above-described embodiments, an electronic equipment to be an equipment under test; EUT is not limited to any particular type of electronic equipment. In addition to structures such as a mobile phone, an electronic computer, and an automatic ticket gate, it includes any components and materials used in an electronic instrument such as an IC chip, assembled circuit boards for electronic component, a semiconductor device, a crystal device, a MEMS device, and various types of electronic sensors.

Note that the present invention is not limited to the above-described embodiments. It is obvious that various changes can be made without departing from the gist of the present invention.

## Claims

1. An apparatus for testing immunity of an electronic equipment against a fluctuating electric field, the apparatus comprising:
an emission electrode for making an electronic equipment to be an equipment under test; EUT exposed to an electric field; and
electric field fluctuating means for fluctuating an intensity of the electric field applied to the electronic equipment during a test,
wherein operating characteristics of the electronic equipment are tested by generating induction charging inside the electronic equipment by means of the fluctuation of the electric field during the test.

2. The apparatus for testing immunity of an electronic equipment against a fluctuating electric field according to claim 1, wherein
the electric field fluctuating means includes a voltage control device that fluctuates the intensity of the electric field by changing a voltage supplied to the emission electrode.

3. The apparatus for testing immunity of an electronic equipment against a fluctuating electric field according to claim 2, wherein
the electric field fluctuating means increases an absolute value of the positive or negative electric field applied to the electronic equipment so as to generate first induction charging in the electronic equipment, then resets a potential of the first induction charging of the electronic equipment, and further decreases the absolute value of the positive or negative electric field so as to generate second induction charging in the electronic equipment whose positive or negative sign is inverted from that of the first induction charging.

4. The apparatus for testing immunity of an electronic equipment against a fluctuating electric field according to any of claims 1 to 3, wherein
a plurality of the emission electrodes are disposed.

5. The apparatus for testing immunity of an electronic equipment against a fluctuating electric field according to claim 4,
assuming that the EUT is a hexahedron, comprising: a first emission electrode disposed so as to face a first face of the hexahedron; and a second emission electrode disposed so as to face a second face of the hexahedron.

6. The apparatus for testing immunity of an electronic equipment against a fluctuating electric field according to claim 4, wherein
assuming that the EUT is a hexahedron, a plurality of the emission electrodes are disposed so as to face a first face of the hexahedron.

7. The apparatus for testing immunity of an electronic equipment against a fluctuating electric field according to claim 6, wherein
the plurality of emission electrodes are disposed side by side to forma single common electric field emission surface.

8. The apparatus for testing immunity of an electronic equipment against a fluctuating electric field according to claim 6 or 7, wherein
the electric field fluctuating means supplies voltages of different timings to the plurality of emission electrodes so that the respective emission electrodes apply the electric fields of different timings to the electronic equipment.

9. The apparatus for testing.immunity of an electronic equipment against a fluctuating electric field according to any of claims 4 to 8, wherein
the electric field fluctuating means fluctuates the electric fields of the plurality of emission electrodes independently of each other so as to control a gradient of an electric field in a space near the electronic equipment.

10. The apparatus for testing immunity of an electronic equipment against a fluctuating electric field according to any of claims 4 to 9, wherein
the plurality of emission electrodes are embedded in a sheet of an insulator.

11. The apparatus for testing immunity of an electronic equipment against a fluctuating electric field according to any of claims 1 to 10, wherein:
the emission electrode is a plate-shaped electrode; and a planar surface of the plate-shaped electrode is faced to the electronic equipment.

12. The apparatus for testing immunity of an electronic equipment against a fluctuating electric field according to any of claims 1 to 10, wherein:
the emission electrode is a plate-shaped electrode; and a side surface of the plate-shaped electrode is faced to the electronic equipment.

13. The apparatus for testing immunity of an electronic equipment against a fluctuating electric field according to any of claims 1 to 10, wherein:
the emission electrode is a rod-shaped electrode; and a side surface of the rod-shaped electrode extending in a longitudinal direction thereof is faced to the electronic equipment.

14. The apparatus for testing immunity of an electronic equipment against a fluctuating electric field according to any of claims 1 to 13, wherein:
the emission electrode includes a plurality of strip-shaped electric field emission surface pieces facing the electronic equipment; and the plurality of electric field emission surface pieces are arranged side by side to form a single electric field emission surface.

15. The apparatus for testing immunity of an electronic equipment against a fluctuating electric field according to claim 14, wherein:
the emission electrode includes a plurality of plate-shaped electrode pieces; and
a planar surface of the plate-shaped electrode piece serves as the strip-shaped electric field emission surface piece.

16. The apparatus for testing immunity of an electronic equipment against a fluctuating electric field according to claim 14, wherein:
the emission electrode includes a plurality of plate-shaped electrode pieces; and
a side surface of the plate-shaped electrode piece serves as the strip-shaped electric field emission surface piece.

17. The apparatus for testing immunity of an electronic equipment against a fluctuating electric field according to claim 14, wherein:
the emission electrode includes a plurality of rod-shaped electrode pieces; and
a side surface of the rod-shaped electrode piece extending in a longitudinal direction thereof serves as the strip-shaped electric field emission surface piece.

18. The apparatus for testing immunity of an electronic equipment against a fluctuating electric field according to claim 14, wherein:
the emission electrode has a strip-shaped projection; and
a tip of the strip-shaped projection serves as the strip-shaped electric field emission surface piece.

19. The apparatus for testing immunity of an electronic equipment against a fluctuating electric field according to any of claims 1 to 18, wherein:
the electric field fluctuating means includes a moving mechanism that changes a relative distance between the electronic equipment and the emission electrode; and
an intensity and a gradient of the electric field are fluctuated by the change in the relative distance.

20. The apparatus for testing immunity of an electronic equipment against a fluctuating electric field according to any of claims 1 to 19, comprising discharge detection means that detects a discharge phenomenon generated by the induction charging inside the electronic equipment.

21. The apparatus for testing immunity of an electronic equipment against a fluctuating electric field according to claim 20, comprising synchronization control means that synchronizes a sensing timing of the discharge detection means with a fluctuating timing of the electric field by the electric field fluctuating means.

22. The apparatus for testing immunity of an electronic equipment against a fluctuating electric field according to any of claims 1 to 21, wherein a high-resistance material is used as a material for the emission electrode.

23. The apparatus for testing immunity of an electronic equipment against a fluctuating electric field according to any of claims 1 to 22, wherein
a high-resistance rubber material is used for a wire for supplying a voltage to the emission electrode.

24. A method for testing immunity of an electronic equipment against a fluctuating electric field, comprising:
externally applying an electric field to an electronic equipment to be an equipment under test; EUT by means of an emission electrode;
fluctuating an intensity and a gradient of the electric field applied to the electronic equipment so as to generate induction charging inside the electronic equipment; and
testing operating characteristics of the electronic equipment with the induction charging.

25. The method for testing immunity of an electronic equipment against a fluctuating electric field according to claim 24, further comprising:
detecting a discharge phenomenon generated by the induction charging inside the electronic equipment; and
testing operating characteristics of the electronic equipment with the discharge phenomenon.

26. The method for testing immunity of an electronic equipment against a fluctuating electric field according to claim 24 or 25, comprising
fluctuating the intensity of the electric field applied to the electronic equipment by changing a voltage supplied to the emission electrode.

27. The method for testing immunity of an electronic equipment against a fluctuating electric field according to any of claims 24 to 26, comprising
fluctuating the intensity and the gradient of the electric field applied to the electronic equipment by changing a relative distance between the emission electrode and the electronic equipment.
